# EUROPEAN PATENT SPECIFICATION

(11) **EP 0 452 506 B1**
(45) Date of publication and mention of the grant of the patent: **13.03.1996**
(21) Application number: 90916081.4
(22) Date of filing: 02.11.1990
(51) Int. Cl.: H01L 21/60

(54) **METHOD OF PRODUCING A FLEXIBLE CIRCUIT BOARD FOR MOUNTING IC's**
VERFAHREN ZUR HERSTELLUNG EINER BIEGSAMEN SCHALTUNGSPLATTE ZUM MONTIEREN VON INTEGRIERTEN SCHALTUNGEN
PROCEDE DE PRODUCTION D'UNE PLAQUETTE A CIRCUITS FLEXIBLE POUR LE MONTAGE DE CIRCUITS INTEGRES

(30) Priority: 06.11.1989 JP 288434/89
(43) Date of publication of application: 23.10.1991
(73) Proprietor: NIPPON MEKTRON, LTD., Minato-ku Tokyo (JP)
(72) Inventor: OOMACHI, Chikafumi, Chiba 277 (JP); TANAKA, Yasuyuki, Ibaraki 300 (JP)
(74) Representative: W.P. Thompson & Co.
(86) International application number: PCT/JP90/01413
(87) International publication number: WO 91/06977

(56) References cited:
- WO-A-87/06766
- FR-A- 2 271 739
- JP-A- 5 353 766
- JP-A- 5 356 969
- JP-A- 5 548 954
- JP-U-53 145 464
- US-A- 3 868 724

## Description

The present invention relates to a process for producing IC-mounting flexible circuit boards capable of directly packaging bare IC chips thereon.

More particularly, the present invention relates to a process for producing IC-mounting flexible circuit boards which includes the steps of forming holes in an insulating base of the flexible circuit board and forming protruding junction conductive portions by plating in the respective holes so that the protruding junction conductive portions can be used to provide electrical connection with the pads of the bare IC-chips.

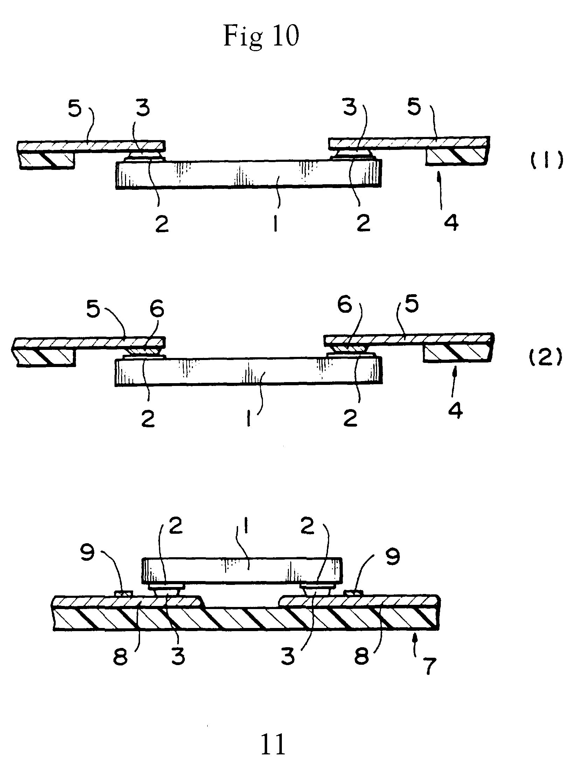

There are known methods of packaging bare IC chips on circuit boards using junction bumps, including the tab method wherein, as shown in Figs. 10(1) and (2) of the accompanying drawings, bumps 3 formed on respective bonding pads 2 of a bare IC chip 1 or bumps 6 formed on respective lead fingers 5 on chip carrier tapes 4 are employed for providing connection by means of heat fusion or ultrasonic bonding, and the flip chip method wherein, as shown in Fig. 11, bumps 3 formed on a bare IC chip 1 are connected to respective conductive patterns 8 of a circuit board 7 by soldering. In the case of the flip chip method, it is common to provide solder-flow preventing dams 9 on the respective conductive patterns 8 as shown in Fig. 11.

In the case of the tab method of Fig. 10 (1), however, a number of steps are required to form the bumps 3 on the bare IC chip 1, which will result in increased costs. Alternatively, although it has been attempted to adopt a method of transferring the bump 6 to the leading end of each lead finger 5 as shown in Fig. 10 (2), this method necessitates not only a transfer bonding step but also the provision of special jigs for making the bumps. Moreover, there is still a limit in increasing its structural density. As a support is not provided for the lead finger 5 in both methods described above, its mechanical strength is insufficient and as the lead finger 5 is provided with no insulating material, the bonding pads 2 cannot be disposed in a zigzag configuration. In addition, because of the projecting structure of the lead finger 5, it is prone to deformation and this makes it difficult to maintain the positional accuracy in the X, Y and Z directions.

In the case of the flip chip method of Fig. 11, on the other hand, the formation of the bumps 3 on the IC bare chip 1 requires a number of steps, which also results in cost increases. Moreover, the necessity of forming the solder-flow preventive dam 9 in the vicinity of each pad of the circuit board 7 also tends to increase the cost further and there is still a limit in increasing its structural density.

It is also known to provide a circuit board with a circuit pattern on one face and conductive connecting members connected to the circuit pattern and extending through the circuit board to form bonding pads at the opposite face of the circuit board. Devices of this type are disclosed in GB 1476888, US 3868724, JP 5356969 and JP 5548954.

An object of the present invention is to provide a method for producing an IC-mounting flexible circuit board.

In accordance with the present invention, there is provided a process for producing a flexible circuit board for integrated circuit mounting comprising the steps of preparing a laminated board having first and second conductive layers non-adhesively joined to respective faces of a flexible insulating base; forming a circuit pattern in the first conductive layer; forming a resistant layer on the second conductive layer having at least one aperture corresponding to a hole to be formed through the second conductive layer and through the flexible insulating base to connect to a portion of the circuit pattern; forming the hole through the second conductive layer and through the flexible insulating base; removing the remaining part of the second conductive layer; and filling the hole with a conductive member by plating, so that one end of the conductive member is connected to the circuit pattern and the other end of the conductive member protrudes from the flexible insulating base forming an integrated circuit mounting pad.

Preferably, the formation of the hole comprises a first step, in which the hole is formed through the second conductive layer and a second step in which the hole is formed through the flexible insulating base.

Preferably, a circuit resist pattern corresponding to the required circuit pattern is formed on the first conductive layer.

Preferably, the aperture in the second conductive layer is formed using an aperture forming resist pattern which is formed on the second conductive layer.

The circuit pattern and the hole through the second conductive layer may be formed in the same step, or alternatively the circuit pattern may be formed after the formation of the hole through the flexible insulating base.

Preferably, the circuit resist pattern and/or the resistant layer comprise(s) an etching resist material.

In an alternative preferred form of the present invention, the circuit resist pattern and/or the resistant layer comprise(s) a dry photoresist film and are (is) provided with a protective film.

Specific embodiments of the present invention will now be described, by way of example only, with reference to the accompanying drawings, in which:-

Fig. 1 is a conceptual sectional block diagram of an IC-mounting flexible circuit board with IC pad junction protrusions according to the present invention.

Fig. 2 is another conceptual sectional block diagram of an IC-mounting flexible circuit board with IC pad junction protrusions disposed zigzag according to the present invention.

Fig. 3 is still another conceptual sectional block diagram of an IC-mounting flexible circuit board with IC pad junction protrusions disposed in such a form as to have circuit wiring patterns on both sides.

Figs. 4 (1) - (3) are sectional block diagrams of the principal parts of IC pad junction protrusions according to the present invention.

Figs. 5 (1) - (4) show a process flow diagram of an IC-mounting flexible circuit board formed using a one-sided flexible conductive laminated board according to the present invention.

Figs. 6 (1) - (5) show a process flow diagram of another IC-mounting flexible circuit board formed similarly according to the present invention.

Figs. 7 (1) - (6) show a process flow diagram of an IC-mounting flexible circuit board formed using two-sided flexible conductive laminated board according to the present invention.

Figs. 8 (1) - (8) show a process flow diagram of another IC-mounting flexible circuit board formed simultaneously using a metal resist pattern when the formation of a circuit wiring pattern is processed according to the present invention.

Figs. 9 (1) - (7) show a process flow diagram of still another IC-mounting flexible circuit board formed similarly using a dry photoresist film with a protective film according to the present invention.

Figs. 10 (1) and (2) are diagrams illustrative of the technique of mounting an IC in the conventional tab method.

Fig. 11 is a diagramm illustrative of the technique of mounting an IC in the conventional flip chip method.

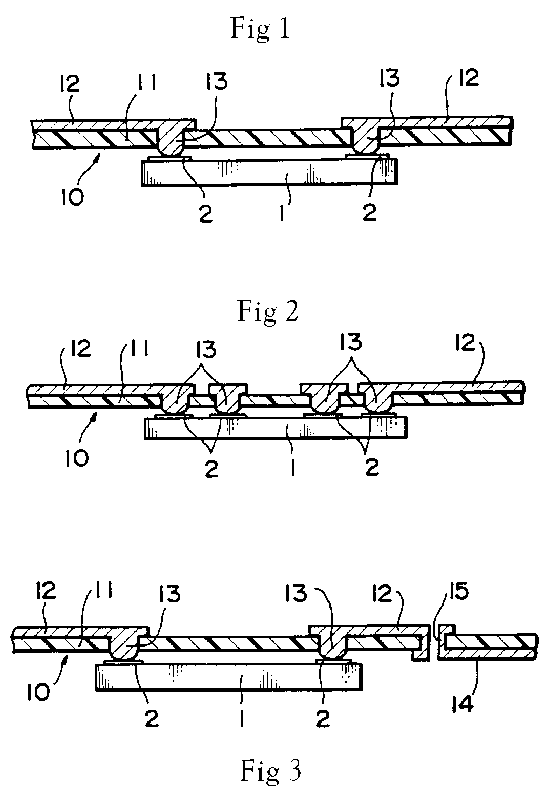

Figs. 1 - 3 show conceptual sectional block diagrams of the principal parts of examples of IC-mounting flexible circuit boards made by a process according to the present invention. As shown in Figs. 1 to 3, numerals 1 and 2 denote a bare IC chip and bonding pads, respectively. The bare IC chip 1 is arranged so that it can be packaged on an IC-mounting flexible circuit board 10 via the pads 2.

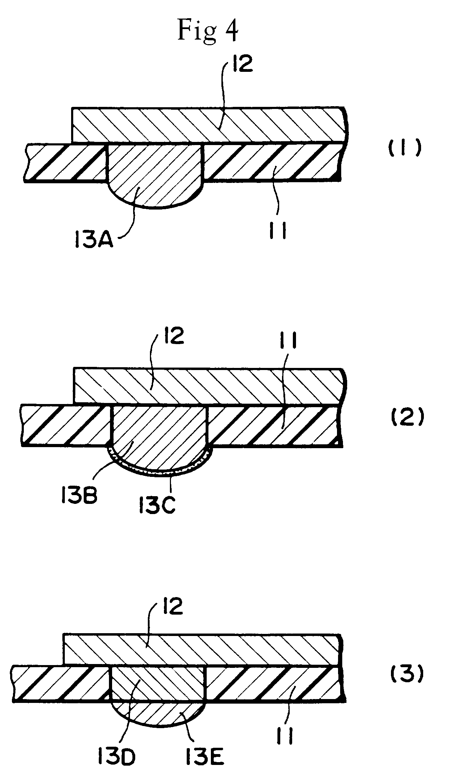

The flexible circuit board 10 comprises a flexible insulating base 11, preferably formed from a polymer such as a polyimide film, a desired circuit wiring pattern 12 mounted on one side of the insulating base 11, and IC pad junction protrusions 13, each of which is electrically joined to the wiring pattern 12 at a predetermined end portion of the circuit wiring pattern 12 and passed through the insulating base 11 so as to protrude onto the bonding pad 2 of the bare IC chip 1. These IC pad junction protrusions 13 may be lined up as shown in Fig. 1 or disposed in a zigzag configuration as shown in Fig. 2 in line with an arrangement of the bonding pads 2 of the bare IC chip 1; in other words, they may freely be disposed as desired. Moreover, it is also possible to construct a two-sided IC-mounting flexible circuit board 10 by suitably forming another circuit wiring pattern 14 on the side from which the IC pad junction protrusions 13 protrude and connecting the desired parts of both the circuit wiring patterns 12, 14 via a connecting through-hole portion 15 in a conventional manner as shown in Fig. 3.

The aforementioned IC pad junction protrusions 13 may be formed in various ways as shown in Figs. 4 (1), (2) and (3). More specifically, Fig. 4 (1) refers to a construction wherein a junction protrusion 13A is wholly formed with a conductive member made of gold, tin, lead-tin alloy or the like that can be readily joined to the IC pad 2; Fig. 4 (2) refers to a construction wherein a junction Protrusion 13B is formed with a copper plating member, wherein an adhered layer 13C formed from a conductive member made of gold, tin, lead-tin alloy or the like is deposited on the protruding outer surface thereof; and Fig. 4 (3) refers to a construction wherein a conductive portion 13D passing through the insulating base 11 is first formed as a copper plated member, whereas the protruding portion is formed of a solder cream or ball capable of reflowing, or formed with a solder member 13E obtained by the adhesion of dip solder to the pertinent portion.

As shown in Fig. 4, the protruding end of such an IC pad junction protrusion is preferably of semicircular cross section. In order to provide a construction for securing ideal bonding properties with respect to the bare IC chip, moreover the use of an adhesive layer between the insulating base 11 and the circuit wiring patterns 12, 14 is omitted as will be described later. In any case, the IC pad junction protrusion 13 is so constructed as to be suitably supported by the flexible insulating base 11 to achieve a high density packaging pattern in a simple manner while securing not only positional accuracy but also mechanical strength.

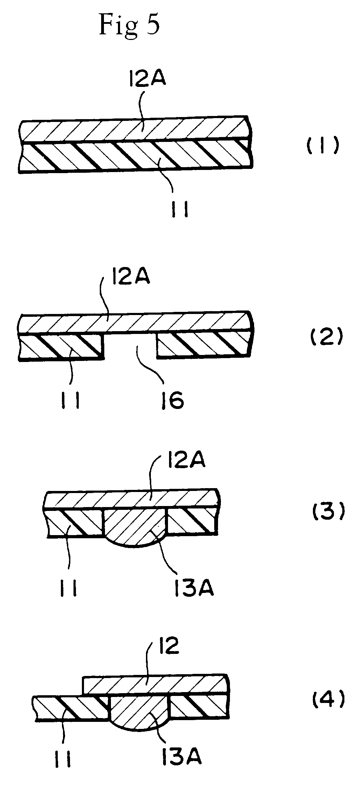

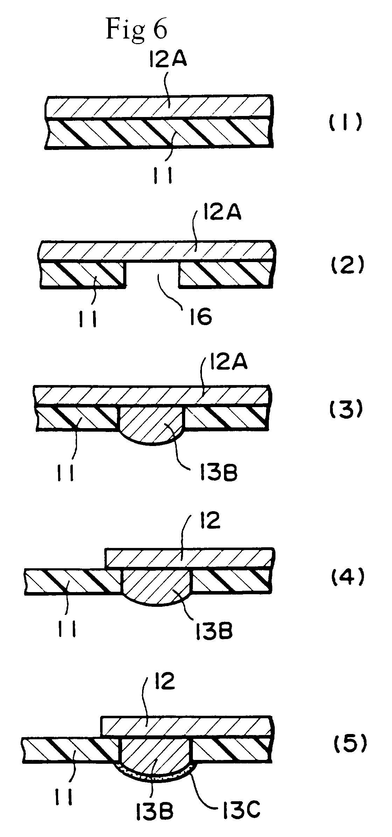

IC-mounting flexible circuit boards of the sort described above can thus be manufactured through various techniques according to the present invention as described hereinafter. Figs. 5 and 6 show exemplified process flow diagrams, not incorporating the present invention. In the technique shown in Fig. 5, a conductive layer 12A such as copper foil is uniformly applied to one side of a flexible insulating base 11 made of imido polymer, a typical example of a polyimide film, without using an adhesive layer therebetween so as to prepare a one-sided, non-adhesive, flexible, conductive laminated board. Such a one-sided, non-adhesive, conductive laminated board can be constructed by forming a first conductive layer through the technique of using a casting means for casting a film member for the insulating base 11 onto the conductive layer l2A, such as copper foil having a predetermined thickness, or sputtering or ion-depositing a conductive member on the insulating film base 11, and forming a thick second conductive layer by plating on the first conductive layer.

In the insulating base 11 of the one-sided non-adhesive flexible conductive laminated board, a hole 16 approximately 50 µm -100 µm across and reaching the conductive layer 12A from the outside is bored, as shown in Fig. 5 (2), using an excimer laser means or using a chemical resin etching means with a strong alkali aqueous solution, such as hydrazine or the like. The hole 16 is thus bored in a predetermined part of the insulating base 11 to expose an area of the conductive layer 12A relative in position to a circuit wiring pattern to be formed later. The hole 16 is then filled with a conductive plating member, forming a conductive member, made of gold, tin, lead-tin alloy or the like that is readily joined to the IC pad, the conductive member being provided by electroplating with or without application of a masking process to the conductive layer 12A. In this way, there is formed the IC pad junction protrusion 13A shown in Fig. 5 (3) having one end tightly joined to the conductive layer 12A, the other protruding adequately from the insulating base 11. After the step of forming the junction protrusion 13A is taken, the conductive layer 12A is patterned by normal etching in conformity with the relative position with the junction protrusion 13A, with or without masking of the protrusion 13A, in order to form a desired circuit wiring pattern 12 as shown in Fig. 5 (4). The IC-mounting flexible circuit board so constructed as described above with reference to Fig. 4 (1) is thus produced.

When the junction protrusion 13B is formed by filling the hole 16 with the conductive member using a copper plating means as shown in Fig. 6 (3) using the technique described above, the protruding outer surface of the junction protrusion 13B formed with the copper plating member as shown in Fig. 6 (5) can be plated with a conductive member made of gold, tin, lead-tin alloy or the like that is readily joined to the IC pad after the patterning of circuit wiring has been so that the adherent layer 13C is formed.

The construction of the IC-mounting flexible circuit board shown in Fig. 4 (2) is thus obtained. In the technique stated above, moreover, the step of filling the hole 16 with the conductive member in Fig. 6 (3) can be changed so that the copper plating member is applied to the hole 16 to form the conductive portion 13D of Fig. 4 (3). Subsequently, a solder cream or ball capable of reflowing can be deposited onto the exposed surface of the conductive portion 13D or otherwise the exposed outer surface thereof is dipped into solder to obtain an IC pad junction protrusion having an additional conductive protrusion 13E that can be readily joined to the IC pad.

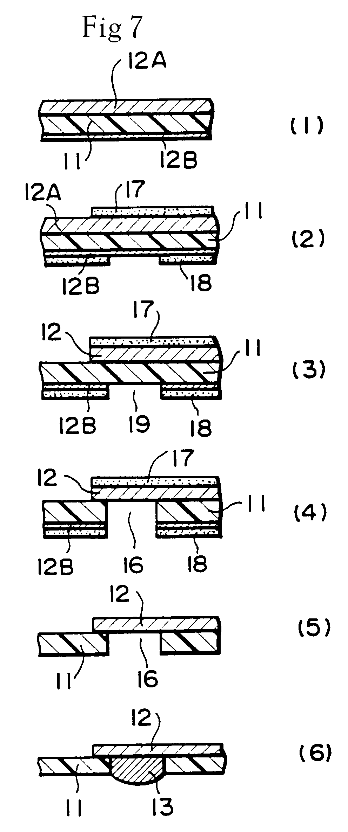

Fig. 7 shows a process flow diagram of one example of a technique in accordance with the present invention for producing a two-sided, non-adhesively bonded, flexible, conductive laminated board equipped with desired conductive layers on both the respective sides of a film-like insulating base made of the aforementioned imido polymer without an adhesive layer therebetween. As shown in Fig. 7 (1), a two-sided, non-adhesively bonded, flexible, conductive laminated board having a thick conductive layer 12A approximately 35 µm thick, for instance, on one side of the insulating base 11 as described above and a thin conductive layer 12B approximately 2 µm thick on the other side, is prepared and a desired circuit wiring resist pattern 17 for use in forming the circuit wiring pattern is formed on the thick conductive layer 12A whereas a hole forming resist pattern 18 is formed on the thin conductive layer 12B for forming a hole in the thin conductive layer 12B by exposing and developing processes using a photoresist agent simultaneously with the resist pattern 17 as shown in Fig. 7 (2). Although various kinds of photoresist agents may be used, one in the form of a dry photoresist film is preferred. If, moreover, an alkali soluble photoresist agent is used, the process of peeling off both the resist patterns 17, 18 simultaneously with the holing process can be conducted when chemical resin etching is employed during the holing step to be taken later.

As shown in Fig. 7 (3), the portion of the thick conductive layer 12A exposed by the circuit wiring resist pattern 17 and the portion of the thin conductive layer 12B exposed by the holing resist pattern 18 are simultaneously removed by etching to form the circuit wiring pattern 12 on one side of the insulating base 11, and to form a hole 19 in the conductive layer 12B at the other side of the insulating base 11. At this stage, a hole 16 is formed in the insulating base 11 by letting the thin conductive layer 12B function as a masking member for a chemical resin etching process using a strong aqueous alkali solution, such as hydrazine or the like, or an excimer laser process. After both the resist patterns 17,18 are removed, the whole of the thin conductive layer 12B is removed by etching as shown in Fig. 7 (5). As the final step, the circuit wiring pattern 12 thus formed is appropriately subjected to a masking process and the technique stipulated with reference to Figs. 4 (1) - (3) is used to form the IC pad junction protrusion 13 by electroplating in the hole 16 as shown in Fig. 7 (6). An IC-mounting flexible circuit board is thereby formed.

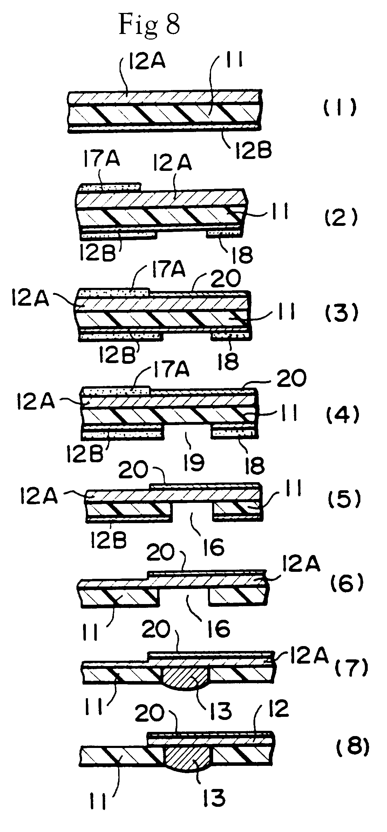

In an alternative embodiment in accordance with the present invention, the processing steps are changed in such a manner as to form a desired circuit wiring pattern by forming a metal resist pattern using an etching resistant conductive member as a plating means of tin, lead, tin nickel alloy, gold or the like as shown in Fig. 8. In the case of this technique, an etching resist pattern 17A is first formed as shown in Fig. 8 (2) in an area on the side of the thick conductive layer 12A other than the portion where the circuit wiring pattern is to be formed and then the holing resist pattern 18 is formed by exposing and developing at the thin conductive layer 12B side. As shown in Fig. 8 (3), the holing exposure portion of the thin conductive layer 12B is then adequately subjected to a masking process and a metal resist pattern 20 as the etching resistant conductive member is formed by an electroplating means using the aforementioned tin, lead, tin nickel alloy, gold or the like in an area corresponding to the desired circuit wiring pattern to be formed on the thick conductive layer 12A. Thereafter, the variation of the technique described above with reference to Fig. 7 comprises the steps of, as shown in Fig. 8 (4) - (8), forming the hole 19 in the thin conductive layer 12B, boring the hole 16 in the insulating base 11, removing the thin conductive layer 12B concurrently with the masking process applied to the side of the thick conductive layer 12A, forming the IC pad junction protrusion 13 by plating in the hole 16 and providing the circuit wiring pattern 12. In this way, it is possible, as shown in Fig. 8, to produce the IC-mounting, flexible circuit board provided with the desired circuit wiring pattern 12 whose surface is covered with the metal resist pattern 20 as the etching resistant conductive member, and the IC pad junction protrusion 13 passing through the insulating base 11, electrically joined to the back end surface of the pattern 12 and protruding from the insulating base 11.

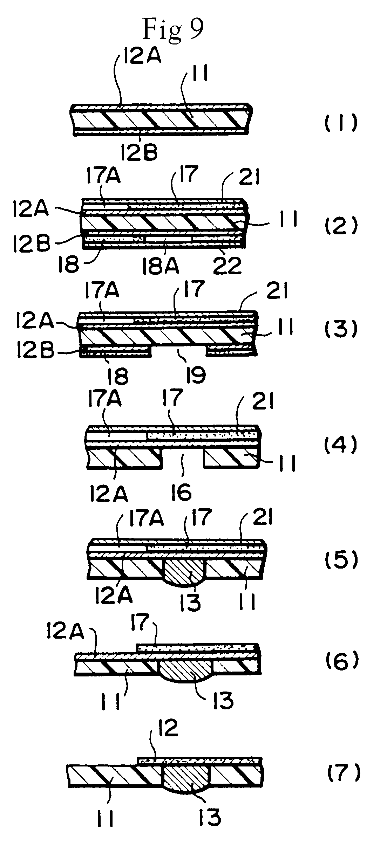

With respect to the production method of Fig. 8, it is also possible to change part of the process of Fig. 7 by not providing the metal resist pattern 20 for the circuit wiring pattern 12 and Fig. 9 shows a process flow diagram for such a method in accordance with the present invention. As in the case of the embodiment shown above, protective films 21,22 in the form of dry photoresist films are respectively uniformly applied to both sides of the flexible, conductive laminated board. As shown in Fig. 7 (2), each side is exposed to light likewise to form the circuit wiring resist pattern 17 and the holing resist pattern 18 as shown in Fig. 9 (2) , whereby with this exposure step, unexposed areas 17A, 18A are being enclosed by the respective protective films 21, 22. Only the protective film 22 on the side of the holing resist pattern 18 is first removed to eliminate the unexposed area 18A through the developing process. As shown in Figs. 9 (3) - (7) then, there are taken the steps of forming the conductive-layer removing portion 19 through the process of removing the holing conductive layer by etching and peeling off the holing resist pattern 18 in the same technique as described above. Subsequently, the hole 16 is bored in the insulating base 11 and the IC pad junction protrusion 13 is formed by plating. At the time these steps are completed, the protective film 21 acting as the masking means is removed and the desired circuit wiring pattern 12 is formed by the circuit wiring patterning process accompanied by the developing process as shown in Figs. 9 (6) - (7). Finally, the junction protrusion 13 for the IC pad is formed, so that an IC-mounting flexible circuit board having the same construction as shown in Fig. 7 is obtained.

References have been made in the embodiments shown to the techniques of forming various IC pad junction protrusions in the forms described above before or after the desired circuit wiring pattern is formed using the one- or both-sided non-adhesive conductive laminated board. Instead of using such a conductive laminated board, however, there may preferably be employed, depending on the intended use, the technique of forming IC pad junction protrusions in the form described above by appropriately forming a desired circuit wiring pattern through the conductive member additive method on at least one side of a flexible insulating base offering excellent heat resistance in company with the resin etching means or the holing step through the laser holing technique applicable to the insulating base. Moreover, consideration may be given to the step of shaping the protrusion properly while the IC pad junction protrusion is being formed or altering or adding various manufacturing processes in accordance with the form of the bare IC chip to be mounted.

Since the IC pad junction protrusion functioning as a bump is embedded in the insulating base and supported thereby in such a state that its leading end protrudes therefrom, it is possible to form an IC pad junction protrusion offering not only excellent mechanical strength but also high positional accuracy.

A plurality of such IC pad junction protrusions may optionally be placed in a zigzag configuration for instance, to enable them to fit with a high-density IC.

The provision of additional solder flow preventive dams in the conventional flip chip method can be dispensed with in the case of the IC-mounting flexible circuit board formed in accordance with the present invention.

Moreover, the step of transferring bumps required in the conventional tab method is also not needed and this contributes to cost reduction.

With the IC pad junction protrusion formed with a solder member as described hereinbefore, the protrusion can be formed still more cheaply.

As the non-adhesive flexible conductive laminated board is used, the chemical resin etching method or excimer laser means may be employed for making it possible to form a very small hole for the formation of the IC pad junction protrusion and the IC-mounting flexible circuit board excellent in heat resistance during the application of the IC bonding process can be produced.

Even when the both-sided flexible conductive laminated board is used, the desired exposure process is applicable to both sides simultaneously, whereby the circuit wiring pattern can be aligned with the IC pad junction protrusion simply and precisely. The highly dense integration of the circuit wiring pattern and the IC pad junction protrusion can be attained as desired.

## Claims

1. A process for producing a flexible circuit board for integrated circuit mounting comprising the steps of preparing a laminated board having first and second conductive layers (12A,12B) non-adhesively joined to respective faces of a flexible insulating base (11); forming a circuit pattern in the first conductive layer (12A); forming a resistant layer (18) on the second conductive layer (12B) having at least one aperture corresponding to a hole (16) to be formed through the second conductive layer (12B) and through the flexible insulating base (11) to connect to a portion of the circuit pattern; forming the hole (16) through the second conductive layer (12B) and through the flexible insulating base (11); removing the remaining part of the second conductive layer (12B); and filling the hole (16) with a conductive member (13) by plating, so that one end of the conductive member (13) is connected to the circuit pattern and the other end of the conductive member (13) protrudes from the flexible insulating base (11) forming an integrated circuit mounting pad.

2. A process as claimed in claim 1, wherein the formation of the hole (16) comprises a first step, in which the hole is formed through the second conductive layer (12B) and a second step in which the hole (16) is formed through the flexible insulating base (11).

3. A process as claimed in claim 1 or 2, wherein a circuit resist pattern (17) corresponding to the required circuit pattern is formed on the first conductive layer (12A).

4. A process as claimed in claim 3, wherein the formation of the circuit pattern and of the hole through the second conductive layer (12B) are achieved in the same step.

5. A process as claimed in claim 1,2 or 3, wherein the circuit pattern is formed after the formation of the hole (16) through the flexible insulating base (11).

6. A process as claimed in any preceding claim wherein the circuit resist pattern (17) comprises an etching resistant conductive material.

7. A process as claimed in any of claims 3 to 6, wherein the circuit resist pattern (17) comprises an etching resistant material.

8. A process as claimed in any of claims 1 to 5, wherein the circuit resist pattern (17) comprises a dry photoresist film and is provided with a protective film.

9. A process as claimed in any preceding claim, wherein the first conductive layer (12A) is thickly formed and the second conductive layer (12B) is thinly formed.

10. A process as claimed in any preceding claim, wherein said hole (16) is formed through the flexible insulating base (11) using chemical resin etching or excimer laser means.

11. A process as claimed in any preceding claim, wherein a plurality of integrated circuit mounting pads are disposed in a zigzag configuration.

## Patentansprüche

1. Verfahren zur Herstellung einer flexiblen Leiterplatte für integrierte Schaltungen, umfassend die folgenden Schritte: Vorbereiten einer beschichteten Platte mit einer ersten und einer zweiten leitenden Schicht (12A, 12B), die nichthaftend mit entsprechenden Seiten einer flexiblen Isolierunterlage (11) verbunden sind; Bilden einer Schaltkreisstruktur in der ersten leitenden Schicht (12A); Bilden einer widerstandsfähigen Schicht (18) auf der zweiten leitenden Schicht (12B) mit wenigstens einer Öffnung, die einem Loch (16) entspricht, das durch die zweite leitende Schicht (12B) und durch die flexible Isolierunterlage (11) zu bohren ist, um einen Teil der Schaltkreisstruktur zu verbinden; Ausbilden des Loches (16) durch die zweite leitende Schicht (12B) und durch die flexible Isolierunterlage (11); Entfernen des verbleibenden Teils der zweiten leitenden Schicht (12B); und Füllen des Loches (16) mit einem leitenden Element (13) durch Kontaktieren, so daß ein Ende des leitenden Elementes (13) mit der Schaltungsstruktur verbunden ist und das andere Ende des leitenden Elementes (13) von der flexiblen Isolierunterlage (11) vorsteht und eine Montageauflage für die integrierte Schaltung bildet.

2. Verfahren nach Anspruch 1, wobei die Ausbildung des Loches (16) einen ersten Schritt beinhaltet, bei dem das Loch durch die zweite leitende Schicht (12B) geführt wird, und einen zweiten Schritt, bei dem das Loch (16) durch die flexible Isolierunterlage (11) geführt wird.

3. Verfahren nach Anspruch 1 oder 2, wobei eine Schaltungsresiststruktur (17), die der gewünschten Schaltungsstruktur entspricht, auf der ersten leitenden Schicht (12A) ausgebildet wird.

4. Verfahren nach Anspruch 3, wobei die Ausbildung der Schaltungsstruktur und des Loches durch die zweite leitende Schicht (12B) in demselben Schritt erzielt werden.

5. Verfahren nach Anspruch 1, 2 oder 3, wobei die Schaltungsstruktur nach der Ausbildung des Loches (16) durch die flexible Isolierunterlage (11) geführt wird.

6. Verfahren nach einem der vorhergehenden Ansprüche, wobei die Schaltungsresiststruktur (17) ein ätzwiderstandsfähiges leitendes Material aufweist.

7. Verfahren nach einem der Ansprüche 3 bis 6, wobei die Schaltungsresiststruktur (17) ein ätzwiderstandsfähiges Material aufweist.

8. Verfahren nach einem der Ansprüche 1 bis 5, wobei die Schaltungsresiststruktur (17) einen trockenen Fotolackfilm aufweist und mit einem Schutzfilm versehen ist.

9. Verfahren nach einem der vorhergehenden Ansprüche, wobei die erste leitende Schicht (12A) dick ausgebildet ist und die zweite leitende Schicht (12B) dünn ausgebildet ist.

10. Verfahren nach einem der vorhergehenden Ansprüche, wobei das genannte Loch (16) durch die flexible Isolierunterlage (11) mit Hilfe von Chemieharzätz- oder Excimerlasermitteln ausgebildet wird.

11. Verfahren nach einem der vorhergehenden Ansprüche, wobei eine Mehrzahl von Montageauflagen für integrierte Schaltungen in einer Zickzack-Konfiguration angeordnet ist.

## Revendications

1. Procédé de production d'une plaquette à circuits flexible pour le montage de circuits intégrés comprenant les opérations de préparation d'une plaquette stratifiée ayant des première et deuxième couches conductrices (12A, 12B), raccordées de manière non adhésive à des faces respectives d'une base isolante flexible (11); formation d'un motif de circuit dans la première couche conductrice (12A); formation d'une couche résistante (18) sur la deuxième couche conductrice (12B) ayant au moins une ouverture correspondant à un trou (16) devant être formé à travers la deuxième couche conductrice (12B) et à travers la base isolante flexible (11) pour rejoindre une partie du motif de circuit; formation du trou (16) à travers la deuxième couche conductrice (12B) et à travers la base isolante flexible (11); élimination de la partie restante de la deuxième couche conductrice (12B); et remplissage du trou (16) par un élément conducteur (13) par placage, de telle sorte qu'une extrémité de l'élément conducteur (13) est connectée au motif de circuit et l'autre extrémité de l'élément conducteur (13) dépasse de la base isolante flexible (11) formant une plage de montage de circuit intégré.

2. Procédé selon la revendication 1, dans lequel la formation du trou (16) comprend une première opération, dans laquelle le trou est formé à travers la deuxième couche conductrice (12B) et une deuxième opération dans laquelle le trou (16) est formé à travers la base isolante flexible (11).

3. Procédé selon la revendication 1 ou 2, dans lequel un motif de résist de circuit (17) correspondant au motif de circuit requis est formé sur la première couche conductrice (12A).

4. Procédé selon la revendication 3, dans lequel les formations du motif de circuit et du trou à travers la deuxième couche conductrice (12B) sont exécutées dans la même opération.

5. Procédé selon la revendication 1, 2 ou 3, dans lequel le motif de circuit est formé après la formation du trou (16) à travers la base isolante flexible (11).

6. Procédé selon l'une quelconque des revendications précédentes, dans lequel le motif de résist de circuit (17) comprend un corps conducteur résistant à l'attaque chimique.

7. Procédé selon l'une quelconque des revendications 3 à 6, dans lequel le motif de résist de circuit (17) comprend un corps résistant à l'attaque chimique.

8. Procédé selon l'une quelconque des revendications 1 à 5, dans lequel le motif de résist de circuit (17) comprend une pellicule de photorésist sèche et est muni d'une pellicule protectrice.

9. Procédé selon l'une quelconque des revendications précédentes, dans lequel la première couche conductrice (12A) est formée de manière épaisse et la deuxième couche conductrice (12B) est formée de manière fine.

10. Procédé selon l'une quelconque des revendications précédentes, dans lequel ledit trou (16) est formé à travers la base isolante flexible (11) en utilisant des moyens d'attaque chimique de résine ou de laser excimère.

11. Procédé selon l'une quelconque des revendications précédentes, dans lequel une pluralité de plages de montage de circuits intégrés sont disposées en une configuration en zig-zag.
